# EUROPÄISCHE PATENTSCHRIFT

(11) **EP 1 567 759 B1**
(45) Veröffentlichungstag und Bekanntmachung des Hinweises auf die Patenterteilung: **04.10.2006**
(21) Anmeldenummer: 03775102.1
(22) Anmeldetag: 31.10.2003
(51) Int. Cl.: F02D 41/20, F02D 41/22, G01R 31/02

(54) **ÜBERWACHUNGSVERFAHREN FÜR EINEN AKTOR UND ZUGEHÖRIGE TREIBERSCHALTUNG**
MONITORING METHOD FOR AN ACTUATOR AND CORRESPONDING DRIVER CIRCUIT
PROCEDE DE SURVEILLANCE POUR ACTIONNEUR ET CIRCUIT D'EXCITATION CORRESPONDANT

(30) Priorität: 03.12.2002 DE 10256456
(43) Veröffentlichungstag der Anmeldung: 31.08.2005
(73) Patentinhaber: SIEMENS AKTIENGESELLSCHAFT, 80333 München (DE)
(72) Erfinder: CHEMISKY, Eric, 67660 Betschdorf (FR); SCHROD, Walter, 93057 Regensburg (DE)
(86) Internationale Anmeldenummer: PCT/DE2003/003635
(87) Internationale Veröffentlichungsnummer: WO 2004/051066

(56) Entgegenhaltungen:
- EP-A- 0 358 972
- EP-A- 1 138 917
- EP-A- 1 139 442
- RUDOLPH G: "INTELLIGENTER DOPPELTREIBER FUER INDUKTIVE LASTEN" ELEKTRONIK, FRANZIS VERLAG GMBH. MUNCHEN, DE, Bd. 42, Nr. 7, 6. April 1993 (1993-04-06), Seiten 86,91-93, XP000356036 ISSN: 0013-5658

## Beschreibung

Die Erfindung betrifft eine Treiberschaltung für einen Aktor, insbesondere für einen piezoelektrischen Aktor für ein Einspritzventil einer Brennkraftmaschine, sowie ein Überwachungsverfahren für eine derartige Treiberschaltung.

In modernen Einspritzanlagen für Brennkraftmaschinen werden piezoelektrische Aktoren als Stellglieder für die Einspritzventile eingesetzt, was im Vergleich zu herkömmlichen Magnetventilen eine hochdynamische Steuerung des Einspritzvorgangs ermöglicht. Der Hub eines derartigen piezoelektrischen Aktors und damit die Ventilstellung des zugehörigen Einspritzventils hängt von dem Ladungszustand ab, so dass der piezoelektrische Aktor entsprechend dem gewünschten Hub aufgeladen bzw. entladen werden muss.

Aus EP 1 138 917 A1 ist eine Treiberschaltung zur elektrischen Ansteuerung eines derartigen piezoelektrischen Aktors bekannt, die einen eingangsseitig angeordneten Gleichspannungswandler sowie einen Ladeschalter und einen Entladeschalter aufweist. Der Ladeschalter verbindet eine mit dem Aktor in Reihe geschaltete Diode mit einer Versorgungsspannung, um den Aktor aufzuladen, während der Entladeschalter den Aktor über die Diode mit Masse verbindet, um den Aktor zu entladen. Durch eine pulsweitenmodulierte Ansteuerung des Ladeschalters und des Entladeschalters lässt sich dann der gewünschte Hub des Aktors erreichen.

Darüber hinaus ermöglicht die bekannte Treiberschaltung auch die Erkennung eines Massekurzschlusses des Aktors. Hierzu wird im Rahmen einer herkömmlichen Fehlerstrommessung der durch den Aktor fließende elektrische Strom sowie der an anderer Stelle des Aktorstromkreises fließende Strom gemessen.

Bei einem fehlerfreien Betrieb müssen die beiden gemessenen Ströme übereinstimmen, wohingegen ein Kurzschluss in dem Aktorstromkreis zu unterschiedlichen Messwerten führt, da der Strom zumindest teilweise über den Kurzschluss abfließt. Die beiden Messwerte werden deshalb miteinander verglichen, wobei in Abhängigkeit von dem Vergleich ein entsprechendes Diagnosesignal erzeugt wird.

Nachteilig an dieser bekannten Treiberschaltung ist zunächst die Tatsache, dass bei einem Kurzschluss innerhalb einer sehr kurzen Zeitspanne von rund 10 µs eine Abschaltung erfolgen muss, um eine Beschädigung der Treiberschaltung zu verhindern.

Ein weiterer Nachteil der bekannten Treiberschaltung besteht darin, dass zur Entkopplung der Fehlerstrommessung von dem eingangsseitig angeordneten Gleichspannungswandler ein relativ hoher schaltungstechnischer Aufwand erforderlich ist. Andernfalls würde der Einfluss des Gleichspannungswandlers auf die Fehlerstrommessung das Messergebnis verfälschen.

Nachteilig an der bekannten Treiberschaltung ist darüber hinaus die Tatsache, dass nicht zwischen einem Kurzschluss nach Masse und einem Kurzschluss gegenüber der Versorgungsspannung unterschieden werden kann.

Der Erfindung liegt somit die Aufgabe zugrunde, eine verbesserte Treiberschaltung bzw. ein entsprechendes Überwachungsverfahren für eine Treiberschaltung zu schaffen, wodurch eine Kurzschlusserkennung und eine Unterscheidung zwischen einem Massekurzschluss und einem Batteriekurzschluss ermöglicht wird.

Diese Aufgabe wird, ausgehend von dem eingangs beschriebenen bekannten Überwachungsverfahren gemäß dem Oberbegriff des Anspruchs 1, durch die kennzeichnenden Merkmale des Anspruchs 1 und hinsichtlich einer entsprechenden Treiberschaltung durch die Merkmale des Anspruchs 9 gelöst.

Die Erfindung umfasst die allgemeine technische Lehre, in Abhängigkeit von dem Vergleich der gemessenen Ströme mindestens drei verschiedene Zustände zu unterscheiden und entsprechend ein Diagnosesignal mit mindestens drei möglichen Zuständen zu erzeugen.

Der im Rahmen der Erfindung verwendete Begriff eines Diagnosesignals mit mehreren möglichen Zuständen ist allgemein zu verstehen und umfasst nicht nur ein Diagnosesignal im engeren Sinne, das beispielsweise drei unterschiedliche Signalpegel annehmen kann. Es ist vielmehr auch möglich, dass das Diagnosesignal aus drei digitalen Signalen besteht, die jeweils einen fehlerfreien Betrieb, einen Massekurzschluss oder einen Kurzschluss gegenüber der Versorgungsspannung anzeigen.

Auch ist die Erfindung nicht auf den eingangs beschriebenen bekannten Typ einer Treiberschaltung beschränkt, sondern auch mit einer andersartigen Treiberschaltung realisierbar. Beispielsweise kann die Treiberschaltung einen Transformator aufweisen, wobei die Primärseite des Transformators über einen Ladeschalter mit einer Versorgungsspannung verbunden ist, während die Sekundärseite über einen Entladeschalter mit dem piezoelektrischen Aktor verbunden ist. Durch eine geeignete pulsweitenmodulierte Ansteuerung des Ladeschalters und des Entladeschalters lässt sich dann der Ladezustand des piezoelektrischen Aktors entsprechend dem gewünschten Hub einstellen, so dass das Einspritzventil zu den vorgegebenen Zeiten entweder öffnet bzw. schließt.

Eine bevorzugte Ausführungsform der Erfindung ermöglicht darüber hinaus nicht nur eine Kurzschlusserkennung, sondern auch eine Erkennung eines Leitungsbruchs. So führt eine Unterbrechung des Aktorstromkreises in der Regel zu einem übermäßigen Spannungsanstieg in dem Aktorstromkreis. Es ist deshalb in dieser Ausführungsform vorgesehen, dass die elektrische Spannung in dem Aktorstromkreis gemessen und das Diagnosesignal in Abhängigkeit von dem Messwert erzeugt wird, wobei das Diagnosesignal zur Unterscheidung eines fehlerfreien Betriebs, eines Massekurzschlusses, Batteriekurzschlusses und einer Leitungsunterbrechung mindestens vier verschiedene Zustände annehmen kann.

Zur Erkennung einer Leitungsunterbrechung anhand der gemessenen Spannung bestehen verschiedene Möglichkeiten, die im folgenden kurz beschrieben werden.

Eine Variante der Erfindung sieht vor, dass der Spannungsanstieg ausgewertet wird, indem beispielsweise die Zeit gemessen wird, die bis zum Erreichen einer vorgegebenen Spannungsschwelle verstreicht. Diese Variante beruht auf der Erkenntnis, dass die Spannung in dem Aktorstromkreis während eines Ladevorgangs besonders schnell ansteigt, wenn die Leitung zu dem Aktor unterbrochen ist.

In einer anderen Variante der Erfindung wird die Spannung gemessen, die sich in dem Aktorstromkreis nach einem Ladeimpuls der Treiberschaltung einstellt. Dieser Messwert wird dann mit der bekannten Zenerspannung der Schutzdiode verglichen, um das Diagnosesignal in Abhängigkeit von dem Vergleich zu erzeugen.

Ferner sieht eine Variante der Erfindung zur Erkennung einer Leitungsunterbrechung vor, die Spannung oberhalb des normalen Arbeitsbereichs während des Ladens zu messen, während der Ladestrom begrenzt oder die Primärseite der Treiberschaltung abgeschaltet wird.

Die erfindungsgemäße Fehlerstrommessung in dem Aktorstromkreis kann auf verschiedene Weise erfolgen, wobei im folgenden einige Möglichkeiten kurz beschrieben werden.

Eine Variante der Erfindung sieht vor, dass der Strom in dem Aktorstromkreis an beiden Messpunkten masseseitig ("Low-Side") erfolgt, indem die Spannung jeweils über einem an Masse geschalteten Widerstand gemessen wird. Vorteilhaft an dieser masseseitigen Fehlerstrommessung an beiden Messpunkten ist der relativ geringe schaltungstechnische Aufwand, da die gemessenen Spannungen dem jeweiligen Strom direkt proportional sind.

In einer anderen Variante der Erfindung erfolgt die Fehlerstrommessung dagegen an beiden Messpunkten in dem Aktorstromkreis spannungsseitig mittels zweier Messwiderstände ("Shunts"), die spannungsseitig in Reihe in dem Aktorstromkreis angeordnet sind. Der Spannungsabfall über diesen Messwiderständen gibt dann den Strom in dem Aktorstromkreis wieder.

In einer weiteren Variante der Erfindung erfolgt die Fehlerstrommessung in dem Aktorstromkreis dagegen an einem Messpunkt durch einen masseseitigen Messwiderstand und an dem anderen Messpunkt durch einen spannungsseitig angeordneten Messwiderstand.

Die vorstehend erwähnte spannungsseitige Fehlerstrommessung kann hierbei auch mit Spulen anstelle eines Messwiderstands erfolgen, was an sich hinlänglich bekannt ist.

In der bevorzugten Ausführungsform der Erfindung ist ferner vorgesehen, dass die Messpunkte für die Fehlerstrommessung von dem Eingang der Treiberschaltung schaltungstechnisch entkoppelt sind, um eine eingangsseitige Verfälschung der Fehlerstrommessung zu vermeiden. Dies ist insbesondere dann sinnvoll, wenn die Treiberschaltung eingangsseitig einen Gleichspannungswandler aufweist. Die Entkopplung der in dem Aktorstromkreis angeordneten Messpunkte für die Fehlerstrommessung von dem Eingang der Treiberschaltung kann beispielsweise durch eine galvanische Trennung erfolgen, indem zwischen dem Eingang der Treiberschaltung und dem Aktorstromkreis ein Transformator angeordnet wird.

Darüber hinaus umfasst die Erfindung auch eine entsprechend ausgestaltete Treiberschaltung, die eine Erkennung und Unterscheidung eines Kurzschlusses gegen Masse und Versorgungsspannung ermöglicht.

Andere vorteilhafte Weiterbildungen der Erfindung sind in den Unteransprüche enthalten oder werden nachstehend zusammen mit der Beschreibung des bevorzugten Ausführungsbeispiels der Erfindung anhand der Zeichnungen erläutert. Es zeigen:
- Figur 1: ein Blockschaltbild einer erfindungsgemäßen Treiberschaltung,
- Figur 2a und 2b: das erfindungsgemäße Überwachungsverfahren für die Treiberschaltung gemäß Figur 1 als Flussdiagramm sowie
- Figur 3a bis 3h: verschiedene Fehlerfälle der Treiberschaltung aus Figur 1.

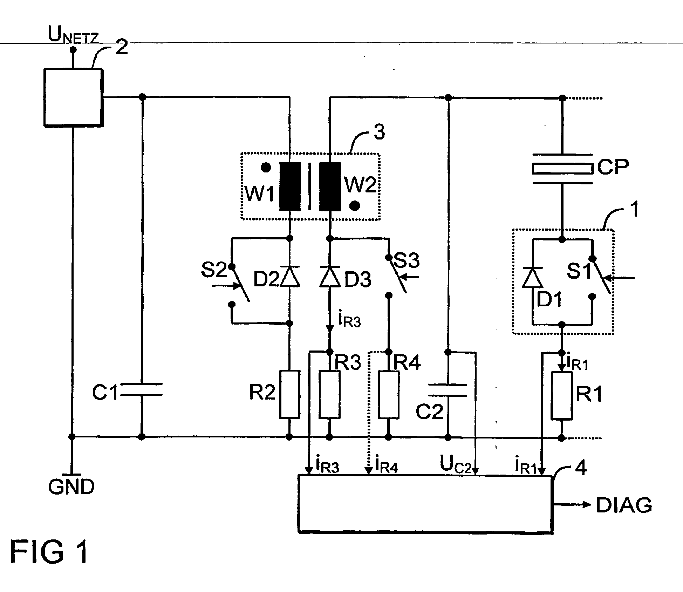

Die in Figur 1 dargestellte Treiberschaltung dient zur elektrischen Ansteuerung piezoelektrischer Aktoren von Einspritzventilen einer Brennkraftmaschine. Zur Vereinfachung ist hierbei nur ein einziger Aktor CP dargestellt, obwohl bei einer mehrzylindrigen Brennkraftmaschine entsprechend der Anzahl von Brennräumen mehrere Aktoren vorhanden sind. Die nicht dargestellten Aktoren sind jedoch identisch aufgebaut und parallel zu dem Aktor CP angeschlossen, wie durch die gestrichelten Linien angedeutet ist.

Der Aktor CP ist - wie die nicht dargestellten weiteren Aktoren für die anderen Brennräume der Brennkraftmaschine - in Reihe mit einem Auswahlschalter 1 und einem Widerstand R1 geschaltet, wobei der Auswahlschalter 1 aus einer Parallelschaltung aus einem Schaltelement S1 und einer Diode D1 besteht. Der Auswahlschalter 1 ermöglicht es, einen der Aktoren für einen Lade- bzw. Entladevorgang auszuwählen, indem der jeweilige Schalter S1 durchschaltet, während die entsprechenden Schalter für die anderen Aktoren trennen.

Die Stromversorgung der Treiberschaltung erfolgt durch einen Spannungswandler 2, der ausgangsseitig durch einen Kondensator C1 gepuffert ist und beim Einsatz in einem Kraftfahrzeug von dem Kraftfahrzeugbordnetz mit einer Netzspannung U_{NETZ}=42V versorgt wird.

Zwischen dem Aktor CP und dem Spannungswandler 2 ist hierbei ein Transformator 3 mit einer Primärwicklung W1 und einer Sekundärwicklung W2 angeordnet, wobei die Primärwicklung W1 mit dem Spannungswandler 2 verbunden ist, während die Sekundärwicklung mit dem Aktor CP verbunden ist.

Die Primärwicklung W1 des Transformators 3 ist in Reihe mit einem Widerstand R2 und einer Parallelschaltung aus einer Diode D2 und einem Ladeschalter S2 geschaltet. Zum Aufladen des Stellgliedes wird der Ladeschalter S2 mit vorgegebener Frequenz und vorgegebenem Tastverhältnis im Pulsbetrieb mit einer vorgegebenen Zahl von Pulsweitenmodulierten Signalen bei der vorgegebenen Ladespannung angesteuert. Während des leitenden Zustandes des Ladeschalters S2 steigt der Strom durch die Primärspule W1 an und wird zu einem vorgegebenen Zeitpunkt durch Öffnen (nichtleitendsteuern) des Ladeschalters S2 abgebrochen. In dieser nichtleitenden Phase der Primärseite fließt über die Sekundärwicklung W2 bei einem dem Windungsverhältnis W2/Wl entsprechenden Strom eine impulsförmige Spannung, die von einem Kondensator C2 geglättet wird, und lädt den Aktor CP mit jedem Strompuls weiter auf, bis schließlich nach der vorgegebenen Zahl von Pulsen eine vorgegebene Aktorspannung in etwa erreicht ist. Der Sekundärkreis wird beim Laden des Aktors CP über den Auswahlschalter 1 geschlossen.

Die Sekundärwicklung W2 des Transformators 3 ist dagegen in Reihe mit zwei parallelen Schaltungszweigen geschaltet, wobei der eine Schaltungszweig aus einer Reihenschaltung einer Diode D3 und einem Widerstand R3 besteht, der den Strom während des Ladevorgangs führt, während der andere Schaltungszweig durch eine Reihenschaltung aus einem Entladeschalter S3 und einem Widerstand R4 gebildet wird und den Strom während des Entladens des Aktors CP führt.

Die Entladung des Aktors CP erfolgt ebenfalls mit pulsweitenmodulierten Signalen dadurch, dass der Entladeschalter S3 pulsförmig leitend und nichtleitend gesteuert wird, wodurch die Aktorspannung sinkt. Dabei fließt der Strom von dem Aktor CP über die Sekundärwicklung W2, den Entladeschalter S3 und den Auswahlschalter 1 zurück zu dem Aktor CP.

Bei jedem Öffnen des Entladeschalters S3 wird ein Teil der Entladeenergie auf die Primärseite des Transformators 3 übertragen und in den Ladekondensator C1 rückgespeichert. Der Primärstromkreis schließt sich über die Diode D2.

Die Ansteuerung des Auswahlschalters 1, des Ladeschalters S2 sowie des Entladeschalters S3 erfolgt in herkömmlicher Weise durch pulsweitenmodulierte Steuersignale und wird deshalb im folgenden nicht weiter detailliert beschrieben.

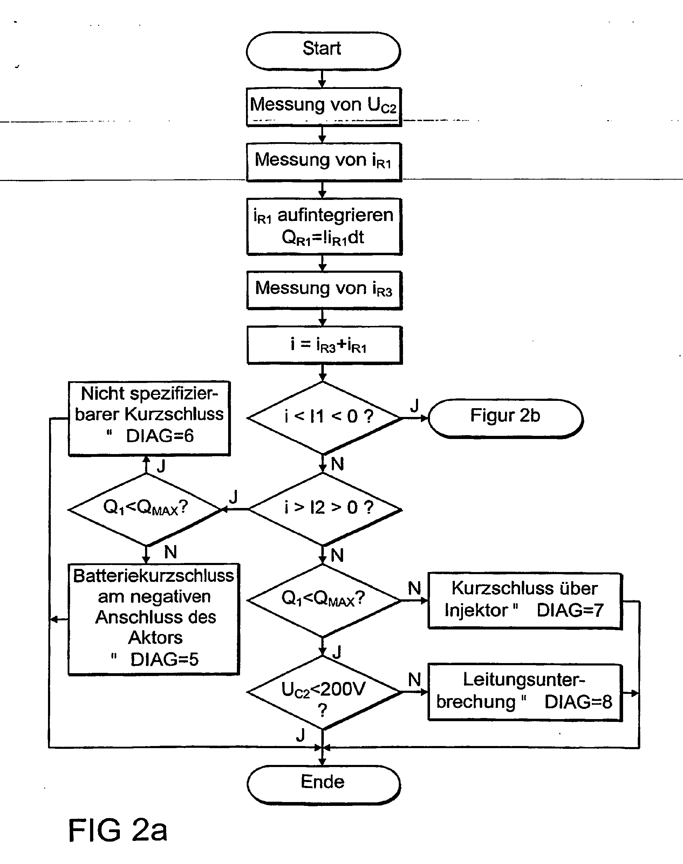

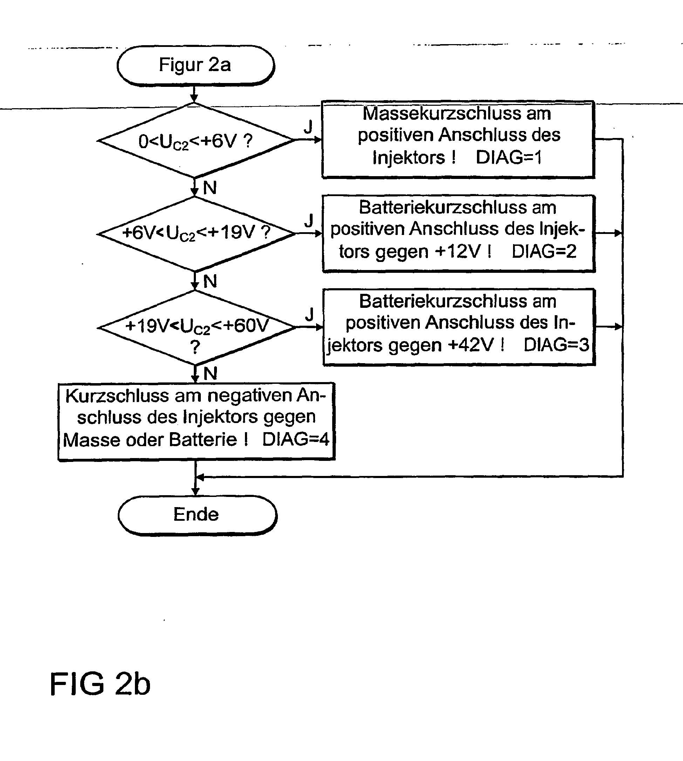

Darüber hinaus weist die Treiberschaltung eine Diagnoseeinheit 4 auf, um einen Kurzschluss des Aktors CP oder eine Leitungsunterbrechung zu erkennen, wie anhand des in den Figuren 2a und 2b dargestellten Flussdiagramms später beschrieben wird.

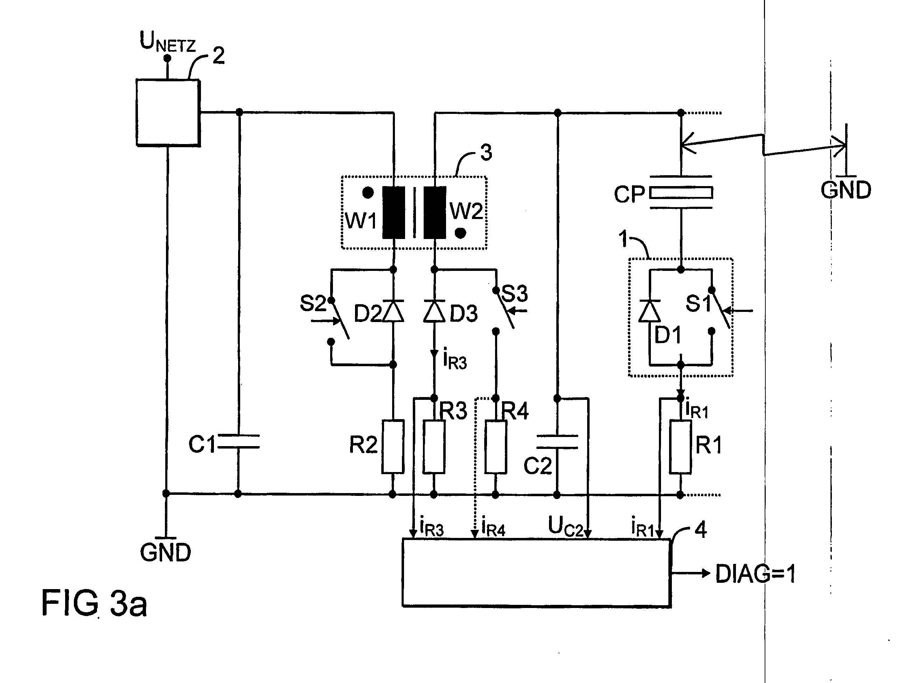

Im folgenden werden zunächst verschiedene Fehlerfälle der Treiberschaltung beschrieben, die in den Figuren 3a bis 3h dargestellt sind und von der Diagnoseeinheit 4 erkannt werden können.

Figur 3a zeigt einen Massekurzschluss am positiven Anschluss des Aktors CP, so dass der Kondensator C2 vollständig über den Massekurzschluss entladen wird. Dies hat zum einen die Folge, dass die von der Diagnoseeinheit 4 gemessene Spannung U_{C2} auf Null abfällt. Zum anderen sind die von der Diagnoseeinheit 4 gemessenen Ströme I_{R1} und I_{R3} in dem Aktorstromkreis bei einem Massekurzschluss an dem positiven Anschluss des Aktors CP nicht mehr exakt gleich, da der Aktorstromkreis dann mehrere Maschen aufweist. Die Diagnoseeinheit 4 kann also anhand einer Messung der Spannung U_{C2} und der Ströme I_{R1} und I_{R3} einen Massekurzschluss am positiven Anschluss des Aktors CP erkennen. Das von der Diagnoseeinheit 4 erzeugte Diagnosesignal DIAG nimmt in diesem Fehlerfall den Wert DIAG=1 an, wobei die Bestimmung des Diagnosesignals DIAG noch detailliert anhand des in den Figuren 2a und 2b gezeigten Flussdiagramms beschrieben wird.

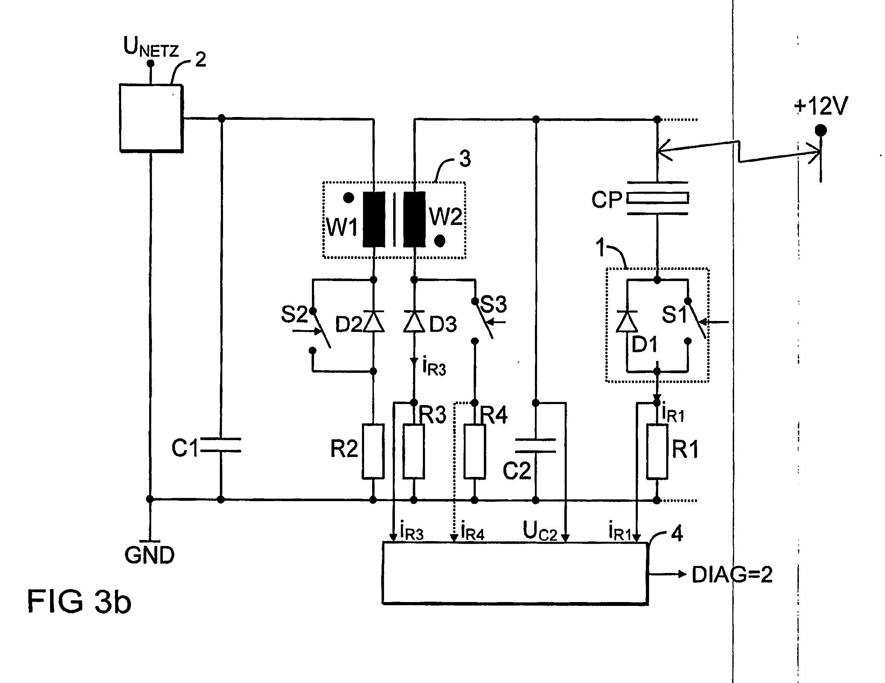

Figur 3b zeigt dagegen einen Kurzschluss gegen eine Batteriespannung von +12V am positiven Anschluss des Aktors CP. Auch in diesem Fall stimmen die beiden Ströme I_{R1} und I_{R3} nicht exakt überein, da der Aktorstromkreis durch den Kurzschluss mehrere Maschen aufweist. Die von der Diagnoseeinheit 4 gemessene Spannung U_{C2} ist hierbei jedoch im wesentlichen gleich der Batteriespannung (U_{C2}≈+12V), was eine Unterscheidung von dem in Figur 3a gezeigten Massekurzschluss am positiven Anschluss des Aktors CP ermöglicht. Das von der Diagnoseeinheit 4 erzeugte Diagnosesignal DIAG nimmt in diesem Fehlerfall den Wert DIAG=2 an, wobei die Bestimmung des Diagnosesignals DIAG noch detailliert anhand des in den Figuren 2a und 2b gezeigten Flussdiagramms beschrieben wird.

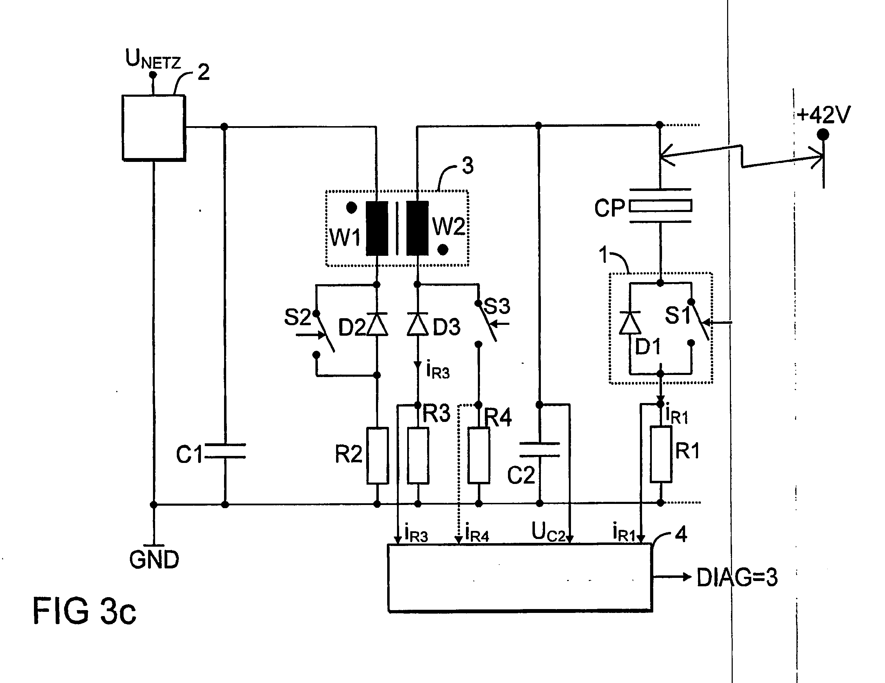

Figur 3c zeigt weiterhin einen Kurzschluss gegen eine Batteriespannung von +42V am positiven Anschluss des Aktors CP. In diesem Fehlerfall stimmen die Ströme I_{R1} und I_{R3} ebenfalls nicht überein, da der Aktorstromkreis durch den Batteriekurzschluss mehrmaschig wird. Die Spannung U_{C2} ist dabei jedoch im wesentlichen gleich der Batteriespannung, d.h. es gilt U_{C2}≈+42V. Das von der Diagnoseeinheit 4 erzeugte Diagnosesignal DIAG nimmt in diesem Fehlerfall den Wert DIAG=3 an, wobei die Bestimmung des Diagnosesignals DIAG noch detailliert anhand des in den Figuren 2a und 2b gezeigten Flussdiagramms beschrieben wird.

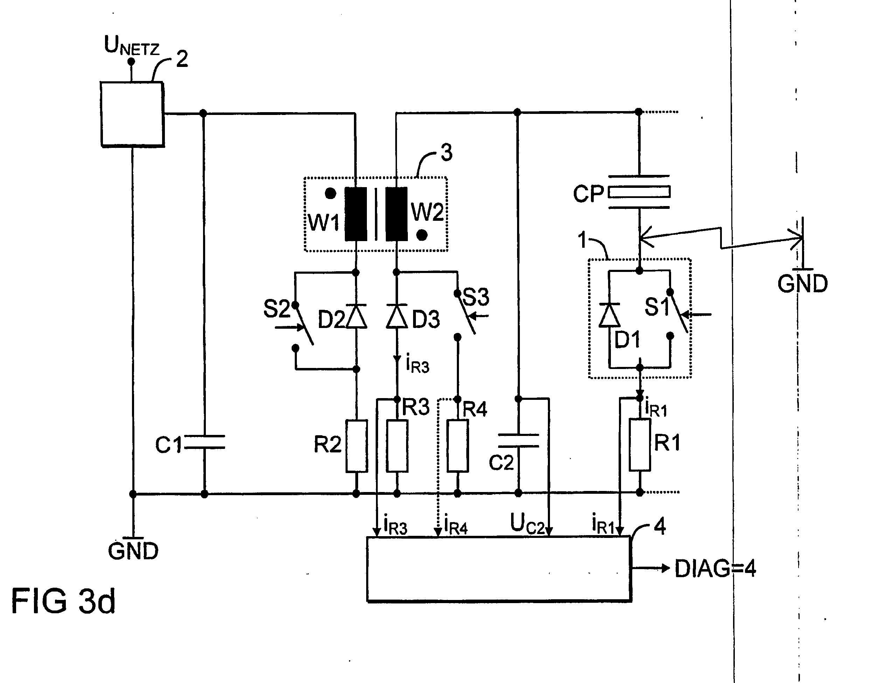

Ferner zeigt Figur 3d einen Fehlerfall der Treiberschaltung, in dem am negativen Anschluss des Aktors CP ein Massekurzschluss auftritt. Dies hat wiederum zur Folge, dass die Ströme I_{R1} und I_{R3} unterschiedliche Werte annehmen, da der Aktorstromkreis durch den Kurzschluss mehrmaschig wird. Die Spannung U_{C2} hängt hierbei jedoch von dem Ladungszustand des Aktors ab und kann deutlich über der Batteriespannung von +42V liegen, was eine Unterscheidung von den vorstehend beschriebenen Fehlerfällen ermöglicht, bei denen die Ströme I_{R1} und I_{R3} ebenfalls unterschiedlich sind. Das von der Diagnoseeinheit 4 erzeugte Diagnosesignal DIAG nimmt in diesem Fehlerfall den Wert DIAG=4 an, wobei die Bestimmung des Diagnosesignals DIAG noch detailliert anhand des in den Figuren 2a und 2b gezeigten Flussdiagramms beschrieben wird.

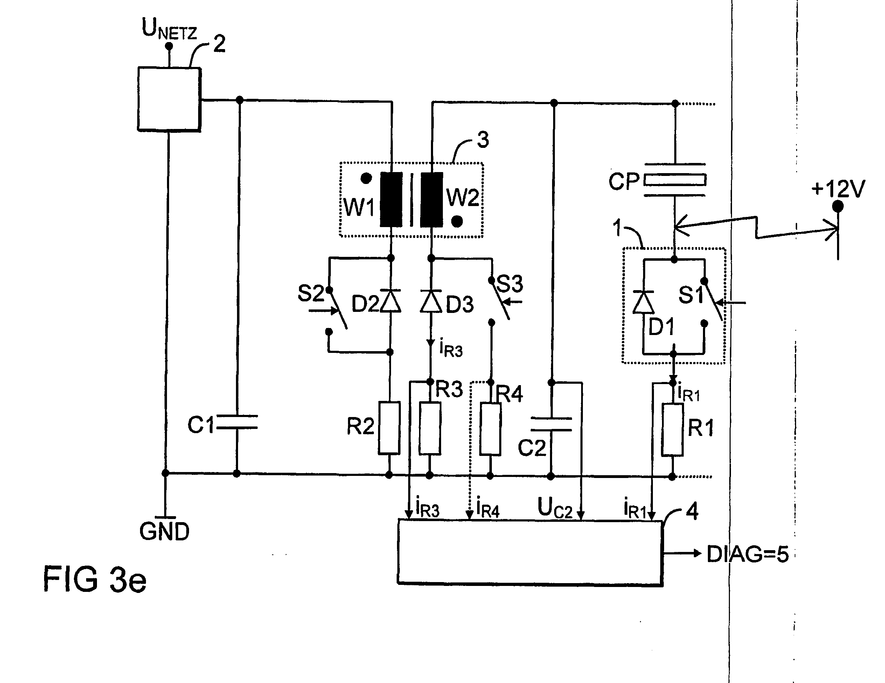

Darüber hinaus zeigt Figur 3e einen Fehlerfall der Treiberschaltung, in dem am negativen Anschluss des Aktors CP ein Kurzschluss gegen eine Batteriespannung von +12V auftritt. Dies hat wiederum zur Folge, dass die Ströme I_{R1} und I_{R3} unterschiedliche Werte annehmen, da der Aktorstromkreis durch den Kurzschluss mehrmaschig wird. Die Spannung U_{C2} hängt hierbei ebenfalls von dem Ladungszustand des Aktors und kann deutlich über der Batteriespannung von +42V liegen, was eine Unterscheidung von den in Figuren 3a bis 3c gezeigten Kurzschlüssen am positiven Anschluss des Aktors CP ermöglicht, bei denen die Ströme I_{R1} und I_{R3} ebenfalls unterschiedlich sind. Das von der Diagnoseeinheit 4 erzeugte Diagnosesignal DIAG nimmt in diesem Fehlerfall den Wert DIAG=5 an, wobei die Bestimmung des Diagnosesignals DIAG noch detailliert anhand des in den Figuren 2a und 2b gezeigten Flussdiagramms beschrieben wird.

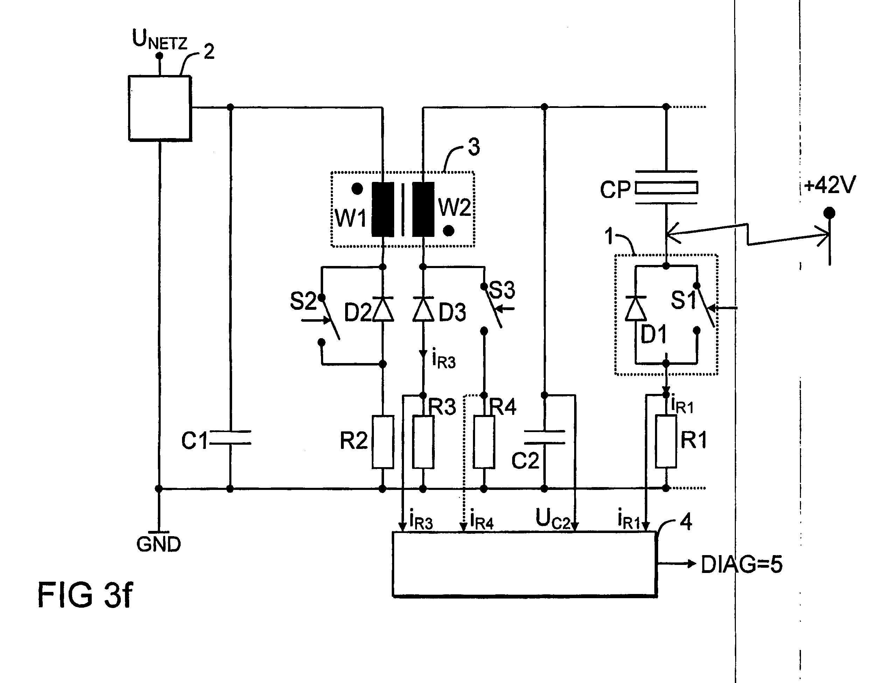

Ferner zeigt Figur 3f einen Fehlerfall der Treiberschaltung, in dem am negativen Anschluss des Aktors CP eine Kurzschluss gegen eine Batteriespannung von +42V auftritt. Hierbei nehmen die Ströme I_{R1} und I_{R3} ebenfalls unterschiedliche Werte an, da der Aktorstromkreis durch den Kurzschluss mehrmaschig wird. Die Spannung U_{C2} hängt hierbei wiederum von dem Ladungszustand des Aktors und kann deutlich über der Batteriespannung von +42V liegen, was eine Unterscheidung von den in Figuren 3a bis 3c gezeigten Kurzschlüssen am positiven Anschluss des Aktors CP ermöglicht, bei denen die Ströme I_{R1} und I_{R3} ebenfalls unterschiedlich sind. Das von der Diagnoseeinheit 4 erzeugte Diagnosesignal DIAG nimmt in diesem Fehlerfall ebenfalls den Wert DIAG=5 an, wobei die Bestimmung des Diagnosesignals DIAG noch detailliert anhand des in den Figuren 2a und 2b gezeigten Flussdiagramms beschrieben wird.

Die in den Figuren 3d bis 3f gezeigten Fehlerfälle mit einem Kurzschluss am negativen Anschluss des Aktors CP lassen sich unterscheiden, wenn man bei einem Kurzschluss zusätzlich die Ladung betrachtet, die während einer vorgegebenen Zeitspanne über den Widerstand R1 gegen Masse abfließt. Diese elektrische Ladung ergibt sich nämlich bei aktiviertem Schalter S1 allein aus der Kurzschlussspannung 0V, +12V bzw. +42V, dem Widerstand R1 und der Integrationszeit. Die dadurch mögliche Unterscheidung der verschiedenen Kurzschlussfälle am negativen Anschluss des Aktors CP wird später anhand der Figuren 2a und 2b detailliert beschrieben.

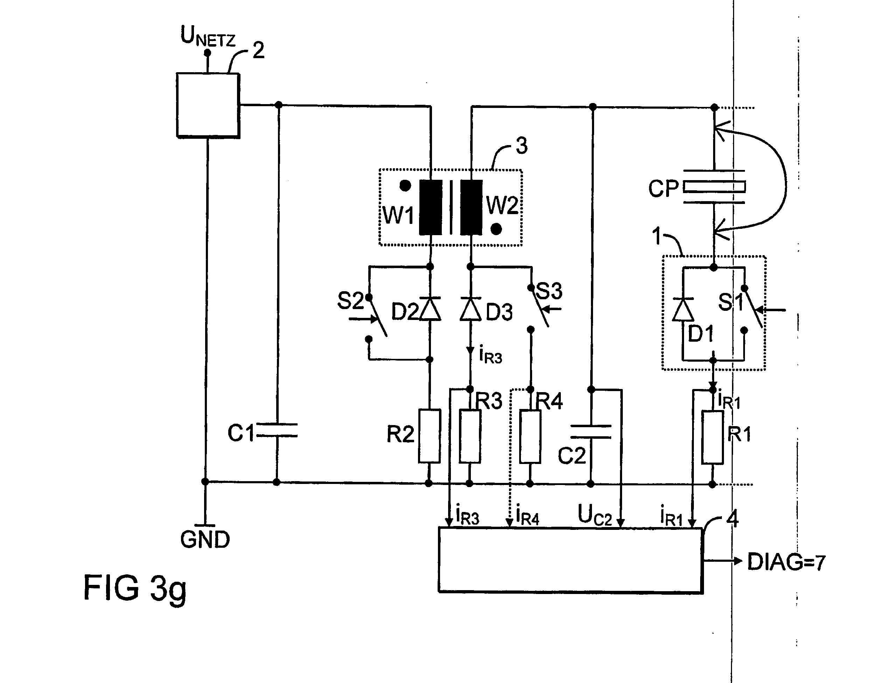

Figur 3g zeigt einen Fehlerfall der Treiberschaltung, bei dem über dem Aktor CP selbst ein Kurzschluss auftritt. In diesem Fall bleibt der Aktorstromkreis einmaschig, so dass die von der Diagnoseeinheit 4 gemessenen Ströme I_{R1} und I_{R3} im wesentlich gleich groß sind. Der in dem Aktorstromkreis fließende Strom I_{R1} ist in diesem Fehlerfall jedoch wesentlich größer. Das von der Diagnoseeinheit 4 erzeugte Diagnosesignal DIAG nimmt in diesem Fehlerfall den Wert DIAG=7 an, wobei die Bestimmung des Diagnosesignals DIAG noch detailliert anhand des in den Figuren 2a und 2b gezeigten Flussdiagramms beschrieben wird.

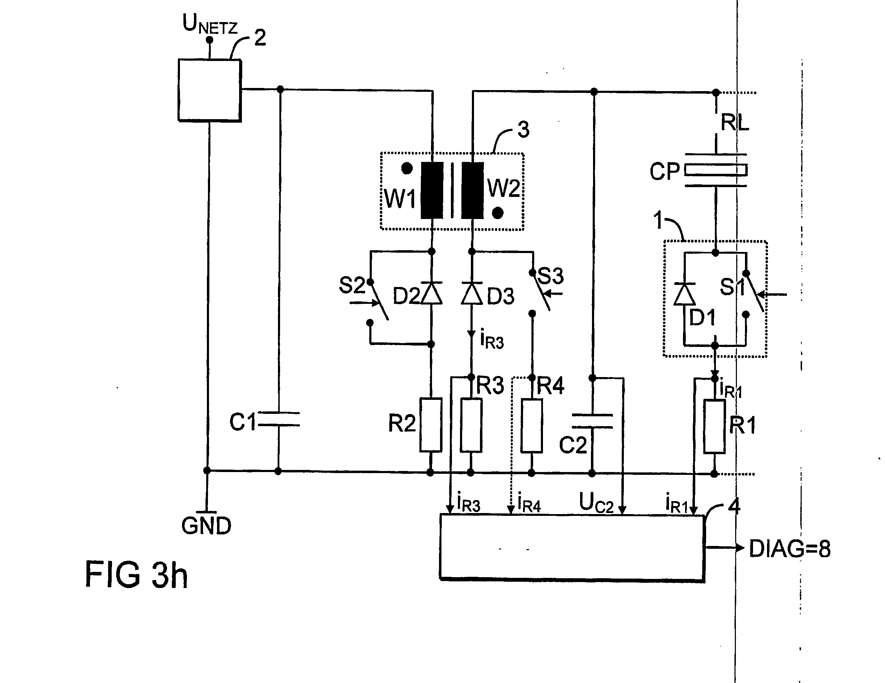

Schließlich zeigt Figur 3h einen Fehlerfall der Treiberschaltung, in dem eine Leitungsunterbrechung in dem Aktorzweig des Aktorstromkreises auftritt. Die Leitungsunterbrechung wird hierbei durch einen unendlichen Leitungswiderstand R_{L} dargestellt. Dies hat zur Folge, dass die Treiberschaltung anstelle des Aktors CP den Kondensator C2 auflädt, so dass die von der Diagnoseeinheit 4 gemessene Spannung U_{C2} auf Werte von mehr als +200V ansteigen kann. Das von der Diagnoseeinheit 4 erzeugte Diagnosesignal DIAG nimmt in diesem Fehlerfall den Wert DIAG=8 an, wobei die Bestimmung des Diagnosesignals DIAG noch detailliert anhand des in den Figuren 2a und 2b gezeigten Flussdiagramms beschrieben wird.

Die folgende Tabelle zeigt die verschiedenen Fehlerzustände und den resultierenden Wert des Diagnosesignals:

| **DIAG:** | **Zeichnung:** | **Fehlerzustand:** |
|---|---|---|
| 0 | Fig. 1 | kein Fehler |
| 1 | Fig. 3a | Massekurzschluss am positiven Anschluss des |
| | | Aktors CP |
| 2 | Fig. 3b | Batteriekurzschluss gegen +12V am positiven |
| | | Anschluss des Aktors CP |
| 3 | Fig. 3c | Batteriekurzschluss gegen +42V am positiven |
| | | Anschluss des Aktors CP |
| 4 | Fig. 3d | Kurzschluss am negativen Anschluss des Ak- |
| | | tors CP gegen Masse oder Batterie |
| 5 | Fig. 3e | Batteriekurzschluss am negativen Anschluss |
| | | des Aktors CP |
| 6 | --- | Nicht spezifizierbarer Kurzschluss |
| 7 | Fig. 3g | Kurzschluss über dem Aktor CP |
| 8 | Fig. 3h | Leitungsunterbrechung |

Im folgenden wird nun anhand der Figuren 2a und 2b das erfindungsgemäße Überwachungsverfahren beschrieben, das von der Diagnoseeinheit 4 durchgeführt wird.

Zunächst misst die Diagnoseeinheit 4 die elektrische Spannung U_{C2}, die über dem Kondensator C2 abfällt. Die Kenntnis dieser Spannung ermöglicht beispielsweise die Unterscheidung der in den Figuren 3a bis 3c dargestellten Kurzschlüsse am positiven Anschluss des Aktors.

Darüber hinaus misst die Diagnoseeinheit 4 mittels eines Spannungsabgriffs die Spannung, die über dem Widerstand R1 abfällt, wobei diese Spannung den Strom i_{R1} wiedergibt, der während des Ladevorgangs in dem Aktorstromkreis durch den Widerstand R1 und den Aktor CP fließt.

Der Strom i_{R1} wird dann über eine vorgegebene Beobachtungsdauer aufintegriert, um die Ladung Q₁ zu ermitteln, die während der Beobachtungsdauer über den Widerstand R1 gegen Masse abfließt. Die Kenntnis der Ladung Q₁ ermöglicht eine Unterscheidung der in den Figuren 3f-3h dargestellten Fehlerfälle, wie noch detailliert beschrieben wird.

Weiterhin misst die Diagnoseeinheit 4 über einen Spannungsabgriff die über dem Widerstand R3 abfallende Spannung, die den Strom i_{R3} wiedergibt, der während des Ladevorgangs im Aktorstromkreis durch den Widerstand R3 fließt.

Bei fehlerfreiem Betrieb ohne Kurzschluss oder Leitungsunterbrechung müssen die Ströme i_{R3} und i_{R1} ohne größere Abweichungen übereinstimmen. Die Diagnoseeinheit 4 berechnet deshalb den Fehlerstrom Δi=i_{R3}+i_{R1} am Massepunkt und vergleicht diese Abweichung Δi mit einem negativen Grenzwert I1<0A und einem positiven Grenzwert I2>0A, um das Diagnosesignal DIAG in Abhängigkeit von dem Vergleich zu erzeugen.

Zunächst wird der Fehlerstrom Δi mit dem negativen Grenzwert I1 verglichen, um zu überprüfen, ob ein Kurzschluss am positiven Anschluss des Aktors CP vorliegt. Bei einem Kurzschluss am positiven Anschluss des Aktors CP ist der Strom i_{R3} nämlich betragsmäßig wesentlich größer als der Strom i_{R1}, so dass der Fehlerstrom Δi den negativen Grenzwert I1 unterschreitet. In diesem Fall setzt die Diagnoseeinheit 4 das erfindungsgemäße Überwachungsverfahren mit den in Figur 2b gezeigten Verfahrensschritten fort, die nachfolgend beschrieben werden.

In Figur 2b wird zunächst überprüft, ob der Kurzschluss am positiven Anschluss des Aktors CP ein Massekurzschluss ist. In diesem Fall muss nämlich die Spannung U_{c2} näherungsweise mit dem Massepotential übereinstimmen. Die Diagnoseeinheit 4 vergleicht die gemessene Spannung U_{C2} deshalb mit Massepotential 0V und mit einem positiven Grenzwert +6V, wobei ein Massekurzschluss angenommen wird, wenn die Spannung U_{C2} innerhalb dieses Spannungsbereichs liegt. Die Diagnoseeinheit 4 setzt das Diagnosesignal DIAG dann auf den Wert DIAG=1, um einen Massekurzschluss am positiven Anschluss des Aktors CP anzuzeigen. Anschließend beendet die Diagnoseeinheit 4 dann das erfindungsgemäße Überwachungsverfahren, da der Fehler erkannt und angezeigt wurde.

Andernfalls prüft die Diagnoseeinheit, ob der Kurzschluss am positiven Anschluss des Aktors CP ein Kurzschluss gegen die Batteriespannung von +12V ist. In einem solchen Fall muss die von der Diagnoseeinheit 4 gemessene Spannung U_{C2} nämlich zwischen +6V und +19V liegen. Die Diagnoseeinheit 4 vergleicht die Spannung U_{C2} deshalb mit diesen Grenzwerten und setzt das Diagnosesignal DIAG ggf. auf einen Wert DIAG=2, um anzuzeigen, dass der positive Anschluss des Aktors CP einen Kurzschluss gegenüber der Batteriespannung von +12V aufweist. Anschließend beendet die Diagnoseeinheit 4 dann das erfindungsgemäße Überwachungsverfahren, da der Fehler erkannt und angezeigt wurde.

Falls die Prüfung der Spannung U_{C2} weder einen Massekurzschluss noch einen Batteriekurzschluss gegen +12V am positiven Anschluss des Aktors CP ergibt, so prüft die Diagnoseeinheit 4 in einem nächsten Schritt, ob der positive Anschluss des Aktors CP einen Kurzschluss gegen die Batteriespannung von +42V aufweist. In diesem Fall muss die von der Diagnoseeinheit 4 gemessene Spannung U_{C2} nämlich zwischen +19V und +60V liegen. Die Diagnoseeinheit 4 vergleicht die Spannung U_{C2} deshalb mit diesen Grenzwerten und setzt das Diagnosesignal DIAG ggf. auf einen Wert DIAG=3, um anzuzeigen, dass der positive Anschluss des Aktors CP einen Kurzschluss gegenüber der Batteriespannung von +42V aufweist. Anschließend beendet die Diagnoseeinheit 4 dann das erfindungsgemäße Überwachungsverfahren, da der Fehler erkannt und angezeigt wurde.

Wenn auch diese Prüfung keinen Kurzschluss am positiven Anschluss des Aktors CP ergibt, so wird in einem nächsten Schritt ein Kurzschluss am negativen Anschluss des Aktors CP angenommen. Hierbei kann jedoch nicht weiter spezifiziert werden, ob der negative Anschluss des Aktors CP einen Kurzschluss gegenüber Masse oder gegenüber Batteriespannung aufweist. Es kann also einer der in den Figuren 3d bis 3f dargestellten Fehlerfälle vorliegen. Die Diagnoseeinheit 4 setzt das Diagnosesignal DIAG dann mangels weiterer Informationen auf den Wert DIAG=4 und beendet anschließend das Überwachungsverfahren.

Im folgenden wird nun die Beschreibung von Figur 2a für den Fall fortgesetzt, dass der Fehlerstrom Δi positiv oder betragsmäßig kleiner als der Grenzwert I1 ist.

In diesem Fall wird in einem nächsten Schritt überprüft, ob der Fehlerstrom Δi den positiven Grenzwert I2 überschreitet.

Falls diese nicht der Fall ist, so sind die beiden Ströme i_{R1} und i_{R3} im wesentlichen gleich groß. Dies lässt den Schluss zu, dass weder ein Batteriekurzschluss noch ein Massekurzschluss vorliegt.

In einem weiteren Schritt wird dann geprüft, ob ein Kurzschluss über dem Aktor CP vorliegt, was als Fehlerfall in Figur 3g dargestellt ist. Hierzu vergleicht die Diagnoseeinheit 4 die über den Widerstand R1 nach Masse abgeflossene Ladung Q₁ mit einem vorgegebenen Grenzwert Q_{MAX}. Falls die Ladung Q₁ den Grenzwert Q_{MAX} überschreitet, so liegt ein Kurzschluss über dem Aktor CP vor und die Diagnoseeinheit 4 setzt das Diagnosesignal DIAG auf den Wert DIAG=7. Anschließend beendet die Diagnoseeinheit 4 dann das erfindungsgemäße Überwachungsverfahren, da der Fehler erkannt und angezeigt wurde.

Andernfalls prüft die Diagnoseeinheit 4 in einem weiteren Schritt, ob der in Figur 3h dargestellte Fehlerfall einer Leitungsunterbrechung vorliegt. Hierzu vergleicht die Diagnoseeinheit 4 die gemessene Spannung U_{C2} mit einem vorgegebenen Grenzwert von +200V. Falls die Spannung U_{C2} den Grenzwert überschreitet, so liegt eine Leitungsunterbrechung vor und die Diagnoseeinheit 4 setzt das Diagnosesignal DIAG auf den Wert DIAG=8. Anschließend beendet die Diagnoseeinheit 4 dann das erfindungsgemäße Überwachungsverfahren, da der Fehler erkannt und angezeigt wurde.

Falls die Überprüfung des Fehlerstroms Δi dagegen ergibt, dass der positive Grenzwert I2 überschritten wird, so muss ein Kurzschluss im Aktorstromkreis vorliegen.

In einem nächsten Schritt wird dann überprüft, ob die über den Widerstand R1 nach Masse abgeflossene Ladung den vorgegebenen Grenzwert Q_{MAX} überschreitet.

Falls dies der Fall ist, so liegt ein Batteriekurzschluss am negativen Anschluss des Aktors CP vor und die Diagnoseeinheit setzt das Diagnosesignal DIAG auf den Wert DIAG=5. Anschließend beendet die Diagnoseeinheit 4 dann das erfindungsgemäße Überwachungsverfahren, da der Fehler erkannt und angezeigt wurde.

Andernfalls liegt dagegen ein nicht näher spezifizierbarer Kurzschluss vor, so dass die Diagnoseeinheit das Diagnosesignal DIAG auf den Wert DIAG=6 setzt und das Überwachungsverfahren anschließend beendet, da der Fehler erkannt und angezeigt wurde.

Bei dem vorstehend beschriebenen Ausführungsbeispiel der Erfindung kann die Fehlererkennung nur während eines Ladevorgangs durchgeführt werden, da nur dann der Strom in dem Aktorstromkreis durch den Widerstand R3 fließt und gemessen werden kann. Während eines Entladevorgangs ist dagegen der Entladeschalter S3 geschlossen, so dass der Strom in dem Aktorstromkreis durch den Widerstand R4 fließt.

In einer Variante der Erfindung wird deshalb zusätzlich der Strom i_{R4} durch den Widerstand R4 gemessen, um auch während eines Entladevorgangs eine Fehlererkennung zu ermöglichen. Hierzu ist zusätzlich ein gestrichelt dargestellter Spannungsabgriff vorgesehen, über den die Diagnoseeinheit 4 den Strom i_{R4} durch den Widerstand R4 misst.

Die Erfindung ist nicht auf das vorstehend beschriebene bevorzugte Ausführungsbeispiel beschränkt. Vielmehr ist eine Vielzahl von Varianten und Abwandlungen möglich.

## Patentansprüche

1. Überwachungsverfahren für einen Aktor (CP), mit den folgenden Schritten:
- Messung des in einem Aktorstromkreis durch den Aktor (CP) fließenden elektrischen Stroms (i_{R1}),
- Messung des in dem Aktorstromkreis vor oder nach dem Aktor (CP) fließenden elektrischen Stroms (i_{R3}),
- Vergleich der beiden gemessenen Ströme (i_{R1}, i_{R3}) zur Erkennung einer Störung,
- Erzeugung eines die Störung anzeigenden Diagnosesignals (DIAG) in Abhängigkeit von dem Vergleich,
**dadurch gekennzeichnet,**
**dass** das Diagnosesignal (DIAG) zur Unterscheidung eines Massekurzschlusses, eines Kurzschlusses gegenüber der Versorgungsspannung und eines fehlerfreien Zustands in Abhängigkeit von dem Vergleich der gemessenen Ströme mindestens drei verschiedene Werte annimmt und
**dass** die elektrische Spannung (U_{C2}) in dem Aktorstromkreis gemessen und das Diagnosesignal (DIAG) in Abhängigkeit von der gemessenen Spannung (U_{C2}) erzeugt wird.

2. Überwachungsverfahren nach Anspruch 1,
**dadurch gekennzeichnet,**
**dass** das Diagnosesignal (DIAG) zur Unterscheidung eines Spannungskurzschlusses gegen eines erste Spannung und eines Spannungskurzschlusses gegen eine zweite Spannung in Abhängigkeit von dem Vergleich der beiden gemessenen Ströme (i_{R1}, i_{R3}) mindestens vier verschiedene Werte annimmt.

3. Überwachungsverfahren nach einem der vorhergehenden Ansprüche,
**dadurch gekennzeichnet,**
**dass** der Spannungsanstieg ermittelt und das Diagnosesignal (DIAG) in Abhängigkeit von dem gemessenen Spannungsanstieg erzeugt wird.

4. Überwachungsverfahren nach einem der vorhergehenden Ansprüche,
**dadurch gekennzeichnet,**
**dass** die Spannung (U_{C2}) während eines Ladevorgangs gemessen und das Diagnosesignal (DIAG) in Abhängigkeit von der gemessenen Spannung (U_{C2}) erzeugt wird.

5. Überwachungsverfahren nach einem der vorhergehenden Ansprüche,
**dadurch gekennzeichnet,**
**dass** die Spannung (U_{C2}) zwischen einem Ladevorgang und einem Entladevorgang gemessen und das Diagnosesignal (DIAG) in Abhängigkeit von der gemessenen Spannung (U_{C2}) erzeugt wird.

6. Überwachungsverfahren nach mindestens einem der vorhergehenden Ansprüche,
**dadurch gekennzeichnet**,
das die Messung des in dem Aktorstromkreis fließenden Stroms (i_{R1}, i_{R2}) an zwei masseseitigen Messpunkten erfolgt.

7. Überwachungsverfahren nach mindestens einem der Ansprüche 1 bis 6,
**dadurch gekennzeichnet**,
das die Messung des in dem Aktorstromkreis fließenden Stroms (i_{R1}, i_{R2}) an zwei spannungsseitigen Messpunkten erfolgt.

8. Überwachungsverfahren nach mindestens einem der Ansprüche 1 bis 6,
**dadurch gekennzeichnet**,
das die Messung des in dem Aktorstromkreis fließenden Stroms (i_{R1}, i_{R2}) an einem masseseitigen Messpunkt und an einem spannungsseitigen Messpunkt erfolgt.

9. Treiberschaltung für einen Aktor (CP), mit
- einem Aktorstromkreis zum Laden und Entladen des in dem Aktorstromkreis angeordneten Aktors (CP),
- einer ersten Messeinrichtung (R1, 4) zur Messung des durch den Aktor (CP) fließenden elektrischen Stroms (i_{R1})
- einer zweiten Messeinrichtung (R3, 4) zur Messung des in dem Aktorstromkreis vor oder nach dem Aktor (CP) fließenden elektrischen Stroms (i_{R3}),
- einer Vergleichereinheit (4) zum Vergleich der beiden gemessenen elektrischen Ströme (i_{R1}, i_{R3}) und zur Erzeugung eines Diagnosesignals (DIAG) in Abhängigkeit von dem Vergleich,
**dadurch gekennzeichnet,**
**dass** das Diagnosesignal (DIAG) zur Unterscheidung eines Massekurzschlusses, eines Kurzschlusses gegenüber der Versorgungsspannung und eines fehlerfreien Zustands in Abhängigkeit von dem Vergleich der gemessenen Ströme (i_{R1}, i_{R3}) mindestens drei verschiedene mögliche Werte aufweist und
**dass** zur Messung der während des Ladevorgangs in dem Aktorstromkreis entstehenden elektrischen Spannung (U_{C2}) eine dritte Messeinrichtung (C2, 4) vorgesehen ist, wobei die dritte Messeinrichtung mit der Vergleichereinheit (4) verbunden ist, um das Diagnosesignal (DIAG) in Abhängigkeit von der gemessenen Spannung (U_{C2}) zu erzeugen.

10. Treiberschaltung nach Anspruch 9, **gekennzeichnet durch**
einen Transformator (3) mit einer Primärwicklung (W1) und einer Sekundärwicklung (W2), wobei die Sekundärwicklung (W2) in dem Aktorstromkreis angeordnet ist,

11. Treiberschaltung nach Anspruch 9 und/oder Anspruch 10,
**dadurch gekennzeichnet,**
**dass** der Aktorstromkreis einen ersten Schaltungszweig (S3, R4) und einen parallelen zweiten Schaltungszweig (D3, R3) aufweist,
wobei der erste Schaltungszweig (S3, R4) einen Entladeschalter (S3) enthält und den elektrischen Strom während des Entladevorgangs führt,
während der zweite Schaltungszweig (D3, R3) eine Diode (D3) enthält und den elektrischen Strom während des Ladevorgangs führt.

12. Treiberschaltung nach mindestens einem der Ansprüche 9 bis 11,
**dadurch gekennzeichnet,**
**dass** die erste Messeinrichtung einen ersten Messwiderstand (R1) aufweist, der mit dem Aktor (CP) in Reihe geschaltet ist.

13. Treiberschaltung nach mindestens einem der Ansprüche 9 bis 12,
**dadurch gekennzeichnet,**
**dass** die zweite Messeinrichtung einen zweiten Messwiderstand (R3) aufweist, der mit der Sekundärwicklung (W2) des Transformators (3) in Reihe geschaltet ist.

14. Treiberschaltung nach Anspruch 13,
**dadurch gekennzeichnet,**
**dass** der zweite Messwiderstand (R3) in dem zweiten Schaltungszweig (D3, R3) angeordnet ist.

15. Treiberschaltung nach mindestens einem der Ansprüche 9 bis 14,
**dadurch gekennzeichnet,**
**dass** die erste Messeinrichtung (R1, 4) und die zweite Messeinrichtung (R3, 4) in dem Aktorstromkreis masseseitig angeordnet sind.

16. Treiberschaltung nach mindestens einem der Ansprüche 9 bis 15,
**dadurch gekennzeichnet,**
**dass** die erste Messeinrichtung und die zweite Messeinrichtung in dem Aktorstromkreis spannungsseitig angeordnet sind.

17. Treiberschaltung nach mindestens einem der Ansprüche 9 bis 15, ,
**dadurch gekennzeichnet,**
**dass** eine der beiden Messeinrichtungen masseseitig angeordnet ist, während die andere Messeinrichtung spannungsseitig angeordnet ist.

18. Treiberschaltung nach mindestens einem der Ansprüche 9 bis 17,
**dadurch gekennzeichnet,**
**dass** die erste Messeinrichtung (R1, 4) und/oder die zweite Messeinrichtung (R3, 4) von dem Schaltungseingang entkoppelt sind.

## Claims

1. Monitoring method for an actuator (CP), with the following steps:
- measurement of the electrical current (i_{R1}) flowing in an actuator circuit through the actuator (CP),
- measurement of the electrical current (i_{R3}) flowing before or after the actuator (CP) in the actuator circuit,
- comparison of the two measured currents (i_{R1}, i_{R3}) for detection of a fault,
- generation of a diagnostic signal (DIAG) indicating the fault depending on the comparison,
**characterized in that**,
the diagnostic signal (DIAG), to distinguish between an earth short circuit, a short circuit to the supply voltage and an error-free state, takes on at least three different values depending on the comparison of the measured currents and
the electrical voltage (U_{C2}) is measured in the actuator circuit and the diagnostic signal (DIAG) is generated as a function of the measured voltage (U_{C2}).

2. Monitoring method in accordance with claim 1,
**characterized in that**,
the diagnostic signal (DIAG), to distinguish between a voltage short circuit against of a first voltage and a voltage short circuit against a second voltage takes on at least four different values depending on the comparison of the two measured currents (i_{R1}, i_{R1}).

3. Monitoring method in accordance with one of the previous claims,
**characterized in that**,
the voltage increase is determined and the diagnostic signal (DIAG) generated depending on the measured voltage increase.

4. Monitoring method according to one of the previous claims,
**characterized in that**,
the voltage (U_{C2}) is measured during a charging process and the diagnostic signal (DIAG) is generated depending on the measured voltage (U_{C2}).

5. Monitoring method according to one of the previous claims,
**characterized in that**,
the voltage (U_{C2}) is measured between of a charging process and a discharging process and the diagnostic signal (DIAG) is generated depending on the measured voltage (U_{C2}).

6. Monitoring method according to at least one of the previous claims,
**characterized in that**,
the current (i_{R1}, i_{R2}) flowing in the actuator circuit is measured at two earth-side measuring points.

7. Monitoring method according to at least one of the claims 1 to 6,
**characterized in that**,
the current (i_{R2}, i_{R2}) flowing in the actuator circuit is measured at two voltage-side measuring points.

8. Monitoring method according to at least one of the claims 1 to 6,
**characterized in that**,
the current (i_{R1}, i_{R2}) flowing in the actuator circuit is measured at one earth-side measuring point and at one voltage-side measuring point.

9. Driver circuit for an actuator (CP), with
- an actuator circuit for charging and discharging the actuator (CP) arranged in the actuator circuit), a first measuring device (R1, 4) for measuring the electrical current (i_{R1}) flowing through the actuator (CP), a second measuring device (R3, 4) for measuring the electrical current (i_{R3}) flowing in the actuator circuit before or after the actuator (CP)
a comparator unit (4) for comparing the two measured electrical currents (i_{R1}, i_{R3}) and for generating a
diagnostic signal (DIAG) depending on the comparison,
**characterized in that**,
the diagnostic signal (DIAG), to distinguish between an earth short circuit, a short circuit to the supply voltage and an error-free state, takes on at least three different values depending on the comparison of the measured currents (i_{R1}, i_{R3}) and
that to measure the electrical voltage (U_{C2}) arising in the actuator circuit during the charging process, a third measuring device (C2, 4) is provided, with the third measuring device being connected to the comparator unit (4) to generate the diagnostic signal (DIAG) depending on the measured voltage (U_{C2}).

10. Driver circuit according to claim 9,
**characterized by**
a transformer (3) with a primary winding (W1) and a secondary winding (W2), with the secondary winding (W2) being arranged in the actuator circuit,

11. Driver circuit according to claim 9 and/or claim 10,
**characterized in that**,
the actuator circuit features a first circuit branch (S3, R4) and a parallel second circuit branch (D3, R3),
with the first circuit branch (S3, R4) containing a discharge switch (S3) and carrying the electrical current during of the discharging process,
while the second circuit branch (D3, R3) contains a diode (D3) and carries the electrical current during the charging process.

12. Driver circuit according to at least one of the claims 9 to 11,
**characterized in that**,
the first measuring device features a first measurement resistor (R1) which is connected in series with the actuator
(CP).

13. Driver circuit according to at least one of the claims 9 to 12,
**characterized in that**,
the second measuring device features a second measurement resistor (R3) which is connected in series with the secondary winding (W2) of the transformer (3).

14. Driver circuit according to claim 13,
**characterized in that**,
the second measurement resistor (R3) is arranged in the second circuit branch (D3, R3).

15. Driver circuit according to at least one of the claims 9 to 14,
**characterized in that**,
the first measuring device (R1, 4) and the second measuring device (R3, 4) are arranged on the earth side of the actuator circuit.

16. Driver circuit according to at least one of the claims 9 to 15,
**characterized in that**,
the first measuring device and the second measuring device are arranged on the voltage side of the actuator circuit.

17. Driver circuit according to at least one of the claims 9 to 15,
**characterized in that**,
one of the two measuring devices is arranged on the earth side while the other measuring device is arranged on the voltage side.

18. Driver circuit according to at least one of the claims 9 to 17,
**characterized in that**,
the first measuring device (R1, 4) and/or the second measuring device (R3, 4) are decoupled from the circuit input.

## Revendications

1. Procédé de surveillance d'un actionneur (CP) comprenant les étapes suivantes :
- la mesure du courant électrique (i_{R1}) circulant dans l'actionneur (CP) monté dans un circuit d'actionneur,
- la mesure du courant électrique (i_{R3}) circulant dans le circuit d'actionneur avant ou après l'actionneur (CP) ,
- la comparaison des deux courants mesurés (i_{R1}, i_{R3}) pour la détection d'un dérangement,
- la génération d'un signal de diagnostic (DIAG) en fonction de la comparaison indiquant le dérangement,
**caractérisé en ce**
**que** le signal de diagnostic (DIAG) prend au moins trois valeurs différentes en fonction des courants mesurés afin de pouvoir distinguer entre un court-circuit vers la masse, un court-circuit vers la tension d'alimentation et un état sans défauts, et
**que** la tension électrique (U_{C2}) dans le circuit d'actionneur est mesurée et le signal de diagnostic (DIAG)est généré en fonction de la tension(U_{C2}) mesurée.

2. Procédé de surveillance selon la revendication 1, **caractérisé en ce que** le signal de diagnostic (DIAG) prend au moins quatre valeurs différentes afin de distinguer entre un court-circuit de tension vers une première tension et un court-circuit de tension vers une deuxième tension en fonction de la comparaison des deux courants mesurés (i_{R1}, i_{R3}).

3. Procédé de surveillance selon l'une des revendications précédentes, **caractérisé en ce que** l'accroissement de tension est déterminé et que le signal de diagnostic (DIAG) est généré en fonction de l'accroissement de tension mesuré.

4. Procédé de surveillance selon l'une des revendications précédentes, **caractérisé en ce que** la tension (U_{C2}) est mesurée au cours d'un processus de charge et que le signal de diagnostic (DIAG) est généré en fonction de la tension mesurée (U_{C2}).

5. Procédé de surveillance selon l'une des revendications précédentes, **caractérisé en ce que** la tension (U_{C2}) entre un processus de charge et un processus de décharge est mesurée et que le signal de diagnostic (DIAG) est généré en fonction de la tension mesurée (U_{C2}).

6. Procédé de surveillance selon au moins une des revendications précédentes, **caractérisé en ce que** la mesure du courant circulant dans le circuit d'actionneur (i_{R1}, i_{R2}) est effectuée en deux points de mesure du côté de la masse.

7. Procédé de surveillance selon au moins une des revendications 1 à 6, **caractérisé en ce que** la mesure du courant circulant dans le circuit d'actionneur (i_{R1}, i_{R2}) est effectuée en deux points de mesure du côté de la tension.

8. Procédé de surveillance selon au moins une des revendications 1 à 6, **caractérisé en ce que** la mesure du courant (i_{R1}, i_{R2}) circulant dans le circuit d'actionneur est effectuée en un point de mesure côté masse et en un point de mesure côté tension.

9. Circuit d'excitation d'un actionneur (CP), comprenant
- un circuit d'actionneur pour charger et décharger l'actionneur (CP) disposé dans le circuit d'actionneur,
- un premier dispositif de mesure (R1, 4) pour mesurer le courant (i_{R1}) circulant dans l'actionneur (CP),
- un deuxième dispositif de mesure (R3, 4) pour mesurer le courant (i_{R3}) circulant dans le circuit d'actionneur avant et après l'actionneur (CP),
- une unité de comparateur (4) pour comparer les deux courants mesurés (i_{R1}, i_{R3}) et pour générer un signal de diagnostic (DIAG) en fonction du résultat de la comparaison,
**caractérisé en ce que** le signal de diagnostic (DIAG) comprend, en fonction de la comparaison des courants mesurés (i_{R1}, i_{R3}), au moins trois valeurs différentes afin de distinguer entre un court-circuit vers la masse, un court-circuit vers la tension d'alimentation et un état sans défauts, et
qu'un troisième dispositif de mesure (C2, 4) est prévu pour mesurer la tension électrique (U_{C2}) générée dans le circuit d'actionneur au cours du processus de charge, le troisième dispositif de mesure (C2, 4) étant relié à l'unité de comparateur (4) afin de générer le signal de diagnostic (DIAG) en fonction de la tension mesurée (U_{C2}).

10. Circuit d'excitation selon la revendication 9, **caractérisé par** un transformateur (3) comprenant un enroulement primaire (W1) et un enroulement secondaire (W2), l'enroulement secondaire (W2) étant disposé dans le circuit d'actionneur.

11. Circuit d'excitation selon la revendication 9 et/ou la revendication 10, **caractérisé en ce que** le circuit d'actionneur comprend une première branche de circuit (S3, R4) et, en parallèle, une deuxième branche de circuit (D3, R3), la première branche de circuit (S3, R4) contenant un interrupteur de décharge (S3) et étant parcouru par le courant électrique au cours du processus de décharge, tandis que la deuxième branche de circuit (D3, R3) contient une diode (D3) et est parcourue par le courant électrique au cours du processus de charge.

12. Circuit d'excitation selon au moins une des revendications 9 à 11, **caractérisé en ce que** le premier dispositif de mesure contient une première résistance de mesure (R1) connectée en série à l'actionneur (CP).

13. Circuit d'excitation selon au moins une des revendications 9 à 12, **caractérisé en ce que** le deuxième dispositif de mesure contient une deuxième résistance de mesure (R3) connectée en série à l'enroulement secondaire (W2) du transformateur (3).

14. Circuit d'excitation selon la revendication 13, **caractérisé en ce que** la deuxième résistance de mesure (R3) est disposée dans la deuxième branche de circuit (D3, R3).

15. Circuit d'excitation selon au moins une des revendications 9 à 14, **caractérisé en ce que** le premier dispositif de mesure (R1, 4) et le deuxième dispositif de mesure (R3, 4) sont disposés du côté de la masse dans le circuit d'actionneur.

16. Circuit d'excitation selon au moins une des revendications 9 à 15, **caractérisé en ce que** le premier dispositif de mesure et le deuxième dispositif de mesure sont disposés du côté de la tension dans le circuit d'actionneur.

17. Circuit d'excitation selon au moins une des revendications 9 à 15, **caractérisé en ce qu'**un des deux dispositifs de mesure est disposé du côté de la masse tandis que l'autre dispositif de mesure est disposé du côté de la tension.

18. Circuit d'excitation selon au moins une des revendications 9 à 17, **caractérisé en ce que** le premier dispositif de mesure (R1, 4) et/ou le deuxième dispositif de mesure (R3, 4) sont découplés de l'entrée du circuit.
